# EUROPEAN PATENT SPECIFICATION

(11) **EP 1 786 046 B1**
(45) Date of publication and mention of the grant of the patent: **08.02.2012**
(21) Application number: 06123835.8
(22) Date of filing: 10.11.2006
(51) Int. Cl.: H01L 45/00, H01L 27/24

(54) **Non-volatile memory device and fabrication method thereof**
Nichtflüchtige Speichervorrichtung und deren Herstellungsverfahren
Dispositif de mémoire non-volatile et procédé de fabrication correspondant

(30) Priority: 11.11.2005 KR 20050108125
(43) Date of publication of application: 16.05.2007
(73) Proprietor: Samsung Electronics Co., Ltd., Suwon-si, Gyeonggi-Do (KR)
(72) Inventor: KIM, Dong-chul, Gyeonggi-do (KR); YOO, In-kyeong, Gyeonggi-do (KR); LEE, Myoung-jae, Gyeonggi-do (KR); SEO, Sun-ae, Gyeonggi-do (KR); BAEK, In-gyu, Gyeonggi-do (KR); AHN, Seung-eon, Gyeonggi-do (KR); PARK, Byoung-ho, Gyeonggi-do (KR); CHA, Young-kwan, Gyeonggi-do (KR); PARK, Sang-jin, Gyeonggi-do (KR)
(74) Representative: Greene, Simon Kenneth

(56) References cited:
- EP-A- 1 484 799
- US-A1- 2005 006 643
- US-A1- 2005 247 921
- US-A1- 2006 108 625
- SEO S ET AL: "Reproducible resistance switching in polycrystalline NiO films" APPLIED PHYSICS LETTERS, AIP, AMERICAN INSTITUTE OF PHYSICS, MELVILLE, NY, US, vol. 85, no. 23, 6 December 2004 (2004-12-06), pages 5655-5657, XP012063730 ISSN: 0003-6951
- FUSCHILLO N ET AL: "Non-linear transport and switching properties of transition metal oxides" JAPANESE JOURNAL OF APPLIED PHYSICS, JAPAN SOCIETY OF APPLIED PHYSICS, TOKYO, JP, vol. 2, no. 1, 1974, pages 817-820, XP002429046 ISSN: 0021-4922

## Description

### BACKGROUND OF THE INVENTION

The present invention relates to a non-volatile memory device using a resistance material, and more particularly, to a non-volatile memory device with an improved structure to have a stable memory switching characteristic in a storage node and a fabrication method thereof.

Ferroelectric random access memory (FRAM), magnetoresistive RAM (MRAM) and phase-change RAM (PRAM) have been developed as non-volatile memory devices using a conventional resistance material. While dynamic RAM (DRAM) and flash memories store binary information using charges, FRAM, MRAM and PRAM store binary information using a polarization characteristic of a ferroelectric material, a resistance change of a magnetic tunnel junction (MTJ) according to a magnetized state of a strong magnetic material, and a resistance change due to a phase change, respectively. Particularly, these FRAM, MRAM and PRAM can be integrated in large scale as like DRAM and are also non-volatile as like flash memories. Hence, FRAM, MRAM and PRAM have been highlighted as potential memories which can replace conventional volatile or non-volatile memories.

Hereinafter, PRAM will be described as an exemplary non-volatile memory device. PRAM retrieves binary information using a certain characteristic of a phase-change material such as GeSbTe (GST). This exemplified phase-change material changes its phase into a crystalline or amorphous state by heat generated regionally when an electric pulse is applied to the phase-change material. In PRAM, a memory cell which stores binary information includes a phase-change layer, a resistor and a switch transistor. The phase-change layer is a GST-based material and is often called chalcogenide. The resistor is used to heat the phase-change layer. Depending on a degree of heat, a resistance value varies since the phase-change layer changes its phase into a crystalline or amorphous state. Also, current flowing into the resistor causes a voltage level to vary, and this variable voltage level makes it possible for PRAM to store and read binary information.

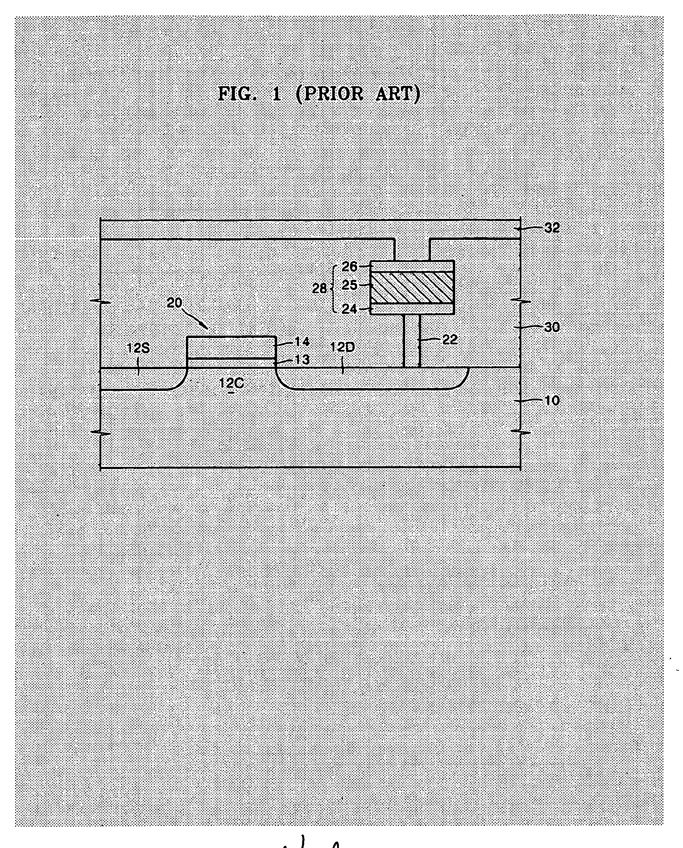

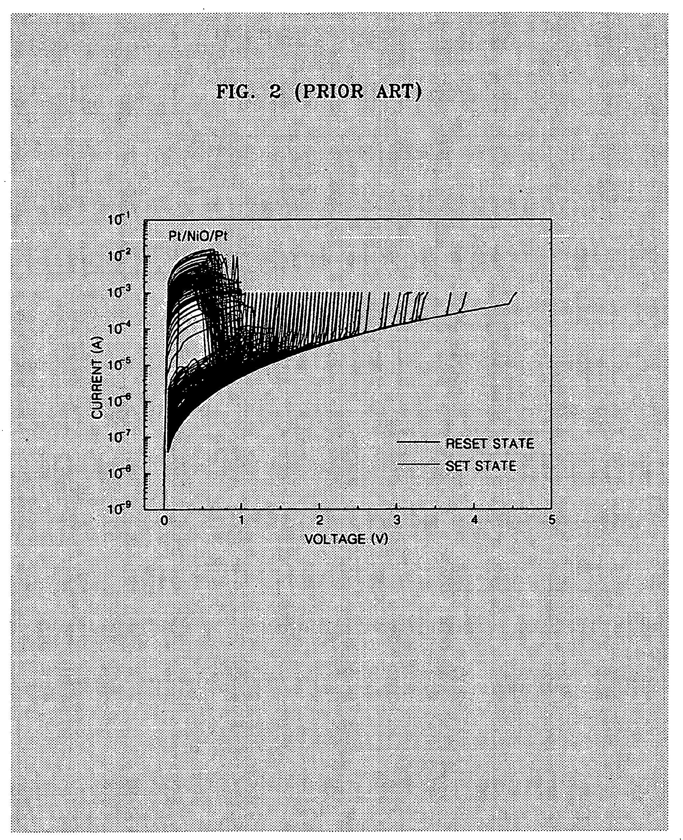

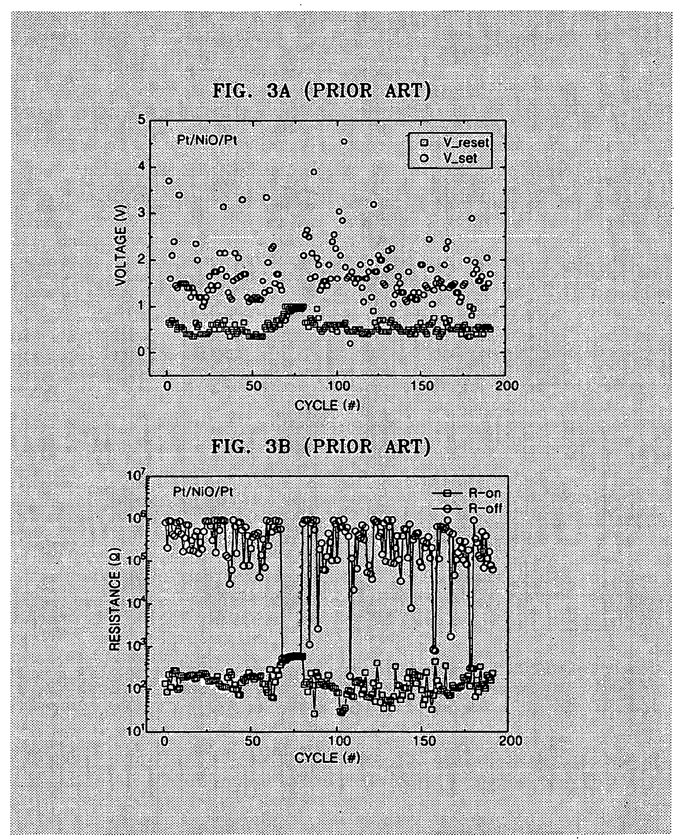

FIG. 1 is a cross-sectional view briefly illustrating a conventional non-volatile memory device. FIG. 2 is a graph illustrating a switching characteristic of a storage node illustrated in FIG. 1. FIG. 3A is a graph illustrating a distribution of set and reset voltage values applied to the storage node illustrated in FIG. 1. FIG. 3B is a graph illustrating a distribution of resistance values of the storage node depending on an on or off state.

Referring to FIG. 1, the conventional non-volatile memory device using a thin NiO layer includes a transistor 20 and a storage node 28 coupled with the transistor 20. The transistor 20 includes a source 12S, a drain 12D, a channel 12C, and a gate electrode 14. The storage node 28 includes an upper electrode 26, a lower electrode 24, and a thin NiO layer 25 disposed therebetween. An insulation layer 30 is disposed between the storage node 28 and the transistor 20. The storage node 28 is coupled with the transistor 20 through a conductive contact plug 22, and a plate electrode 32 is formed over the upper electrode 27.

The storage node 28 of the conventional non-volatile memory device has an M-I-M memory cell structure. Herein, 'M' represents metal-based upper and lower electrodes, and 'I' represents a NiO layer, which is a resistance material. In a conventional resistance material implemented memory device, which has the M-I-M memory cell structure, set voltage values Vₛₑₜ and reset voltage values Vᵣₑₛₑₜ applied to a storage node during repetitive switchings may be distributed with a large deviation. In the case of repetitive switchings, the storage node may have non-uniform resistance values Rₒₙ and R_{off} depending on an on or off state.

As a result, a stable memory switching characteristic may not be achieved in the conventional non-volatile memory device. Accordingly, the conventional storage node structure needs to be improved.

A nonvolatile memory device is taught by EP 1484799. In this document, a data storage unit has a data storage layer with different resistance characteristics in different voltage ranges, for example NiO, V₂O₅, ZnO, Nb₂O₅, TiO₂, WO₃ and CoO. The data storage material may be sandwiched between upper and lower electrodes.

### SUMMARY OF THE INVENTION

According to an aspect of the present invention, there is provided a non-volatile memory device according to claim 1.

The conductive metal oxide may be one selected from the group consisting of IrO₂, RuO₂, SrRuO₃, MoO₂, OsO₂, ReO₂, RhO₂, WO₂, and indium tin oxide (ITO). The at least one contact layer may have a thickness ranging from approximately 10 Å to approximately 500 Å. The transition metal oxide may be an oxide of a metal selected from the group consisting of Ni, Nb, Ti, Zr, Hf, Co, Fe, Cu, and Cr. Each of the first electrode and the second electrode may be formed of a material selected from the group consisting of Ir, Pt, Ru, W, TiN, and polysilicon. The switching device may be a transistor or a diode.

According to another aspect of the present invention, there is provided a method of fabricating a non-volatile memory deviceaccording to claim 7.

The above method may further include forming a second contact layer on the data storage layer using a conductive metal oxide between the forming of the data storage layer and the forming of the second electrode.

The conductive metal oxide may be one selected from the group consisting of IrO₂, RuO₂, SrRuO₃, MoO₂, OsO₂, ReO₂, RhO₂, WO₂, and ITO (indium tin oxide). The contact layer may be formed to a thickness ranging from approximately 1nm (10 Å) to approximately 50 nm (500 Å). The transition metal oxide may be an oxide of a metal selected from the group consisting of Ni, Nb, Ti, Zr, Hf, Co, Fe, Cu, and Cr. Each of the first electrode and the second electrode may be formed of a material selected from the group consisting of Ir, Pt, Ru, W, TiN, and polysilicon. The switching device may be a transistor or a diode.

The present invention aims to provide a non-volatile memory device with an improved structure to have a stable memory switching characteristic in a storage node and a fabrication method thereof.

According to the exemplary embodiments of the present invention, the non-volatile memory device is implemented with an improved structure, which provides a stable switching characteristic in the storage node.

### BRIEF DESCRIPTION OF THE DRAWINGS

The above and other features and advantages of the present invention will become more apparent by describing in detail exemplary embodiments thereof with reference to the attached drawings in which:
FIG. 1 is a cross-sectional view briefly illustrating a conventional non-volatile memory device;
FIG. 2 is a graph illustrating a switching characteristic of a storage node illustrated in FIG. 1;
FIG. 3A is a graph illustrating a distribution of set and reset voltage values applied to the storage node illustrated in FIG. 1;
FIG. 3B is a graph illustrating a distribution of resistance values of the storage node depending on an on or off state;
FIG. 4 is a cross-sectional view briefly illustrating a non-volatile memory device according to an embodiment of the present invention;
FIG. 5 is a graph exhibiting a switching characteristic of a storage node illustrated in FIG. 4;
FIG. 6A is a graph illustrating a distribution of set and reset voltage values applied to the storage node illustrated in FIG. 4;
FIG. 6B is a histogram of the set and reset voltage values illustrated in FIG. 6A;
FIG. 7A is a graph illustrating a distribution of resistance values of the storage node depending on an on or off state;
FIG. 7B is a histogram of the resistance values of the storage node illustrated in FIG. 7A; and
FIGS. 8A through 8E are cross-sectional views illustrating a method of fabricating a non-volatile memory device according to an embodiment of the present invention.

### DETAILED DESCRIPTION OF THE INVENTION

The present invention will now be described more fully with reference to the accompanying drawings, in which exemplary embodiments of the invention are shown. In the drawings, the thicknesses of layers and regions are exaggerated for clarity.

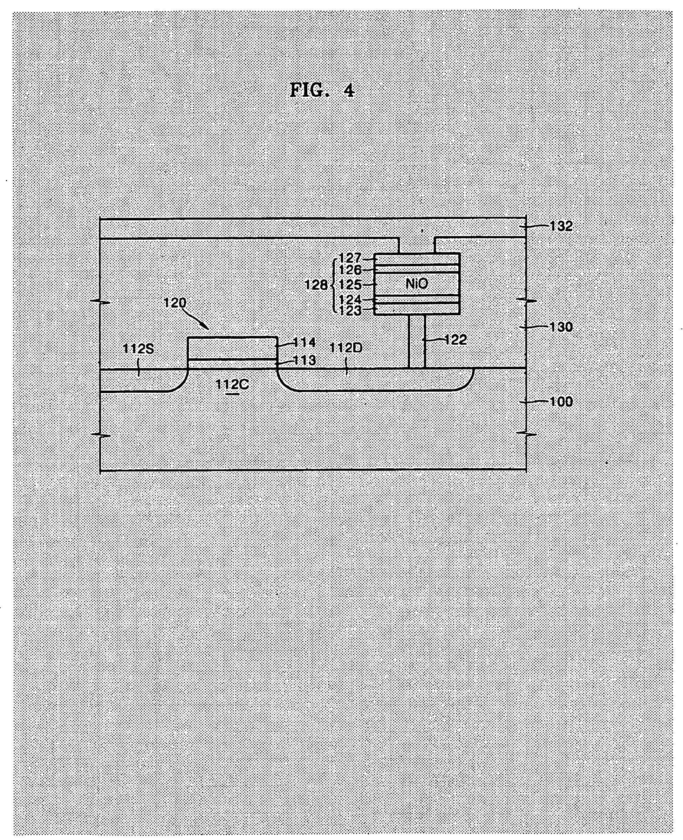

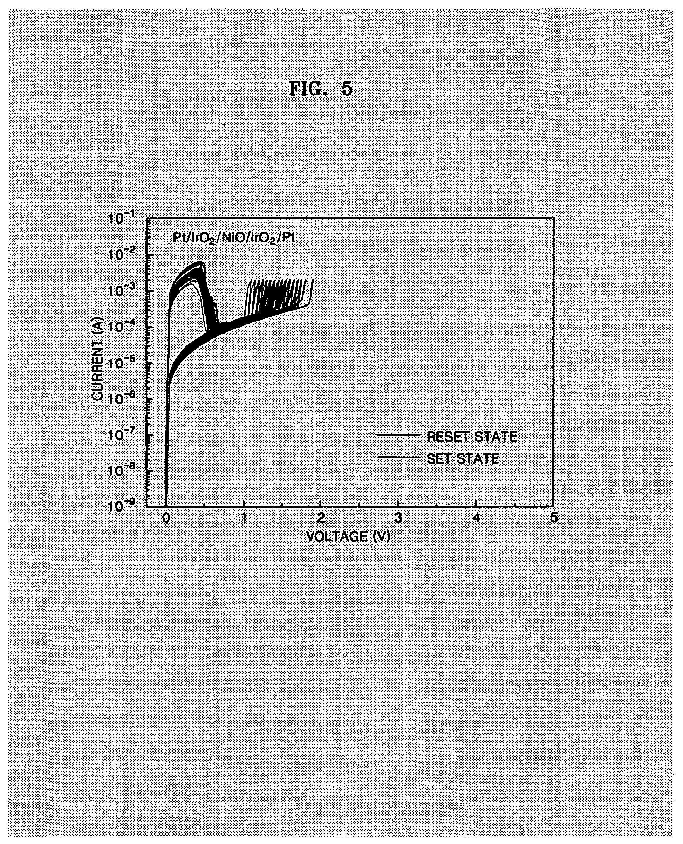

FIG. 4 is a cross-sectional view briefly illustrating a non-volatile memory device according to an embodiment of the present invention. FIG. 5 is a graph illustrating a switching characteristic of a storage node illustrated in FIG. 4.

With reference to FIGS. 4 and 5, the non-volatile memory device includes a transistor 120 and a storage node 128. The transistor 120 is a switching device, and the storage node 128 is coupled with the transistor 120. An insulation layer 130 is disposed between the storage node 128 and the transistor 120, and a conductive contact plug 122 couples the storage node 128 with the transistor 120. A plate electrode 132 is disposed over the storage node 128 and coupled with the storage node 128. The transistor 120 includes a source 112S, a drain 112D, a channel 112C, and a gate electrode 114. Since a structure of the transistor 120 and a fabrication method thereof are well known in the art, detailed description thereof will be omitted. Also, instead of the transistor 120, other switching devices, e.g., diodes, can be used. A diode structure and a fabrication method thereof are also well known in the art, detailed description thereof will be omitted. Hereinafter, the exemplary embodiment of the present invention will be described in detail on the basis of the transistor.

The storage node 128 includes a first electrode 123, a second electrode 127, a data storage layer 125 disposed between the first electrode 123 and the second electrode 127, and first and second contact layers 124 and 126 disposed at least beneath or above the data storage layer 125.

The data storage layer 125 becomes a reset state or a set state depending on a voltage level applied to the data storage layer 125 (refer to FIG. 5). Since the data storage layer 125 has different resistance values for each state, binary information can be stored and read based on a difference between the resistance values. The data storage layer 125 can include a transition metal oxide or aluminum oxide. The transition metal oxide is an oxide of a metal selected from the group consisting of nickel (Ni), niobium (Nb), titanium (Ti), zirconium (Zr), hafnium (Hf), cobalt (Co), iron (Fe), copper (Cu), and chrome (Cr). The first electrode 123 and the second electrode 127 includes one selected from the group consisting of iridium (Ir), platinum (Pt), ruthenium (Ru), tungsten (W), titanium nitride (TiN), and polysilicon.

The first and second contact layers 124 and 126 include a conductive metal oxide, and because the first and second contact layers 124 and 126 are formed at least beneath or above the data storage layer 125, the first and second contact layers 124 and 126 can improve interfacial characteristics between the data storage layer 125 and the lower electrode 123 and between the upper electrode 127 and the data storage layer 125. The conductive metal oxide is one selected from the group consisting of IrO₂, RuO₂, SrRuO₃, MoO₂, OsO₂, ReO₂, RhO₂, WO₂, and indium tin oxide (ITO). The first and second contact layers 124 and 126 have a thickness ranging from approximately 1 nm (10 Å) to approximately 50 nm (500 Å).

Compared with the conventional M-I-M memory cell structure, the storage node 128 of the non-volatile memory device according to the present embodiment can have an M-B-I-B-M, M-B-I-M or M-I-B-M memory cell structure. Herein, 'M' represents the first electrode 123 and the second electrode 127 both including a metal or conductive material. Also, 'I' and 'B' represent the data storage layer 125 and the first and second contact layers 124 and 126, respectively.

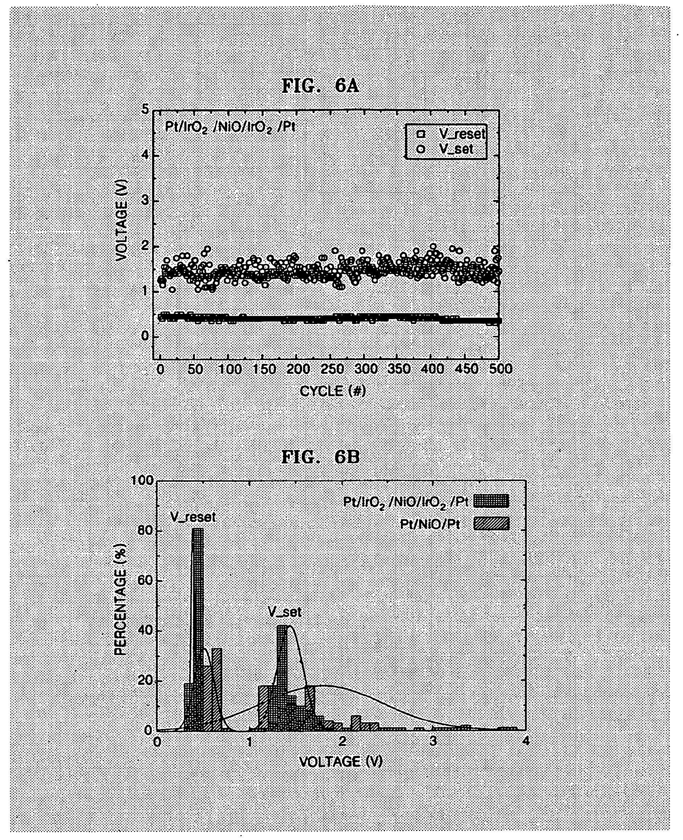

The conventional resistance material based memory device with the M-I-M memory cell structure often has limitations in that set and reset voltage values Vset and Vreset applied to the storage node during repetitive switchings are distributed with a large deviation and resistance values Ron and Roff of the storage node depending on an on or off state are not distributed uniformly. However, according to the present embodiment, these limitations can be improved by improving the interfacial characteristics between the data storage layer 125 and the first electrode 123 and between the data storage layer 125 and the upper electrode 127. In more detail, in the case of repetitive switching, the resistance values of the storage node 128 can be distributed with a decreased level of deviation due to the improved interfacial characteristics as compared with the conventional resistance material based memory device. Therefore, the storage node 128 can have a stable memory switching characteristic. FIGS. 6A through 7B illustrate an improved memory switching characteristic in the non-volatile memory device according to the embodiment of the present invention.

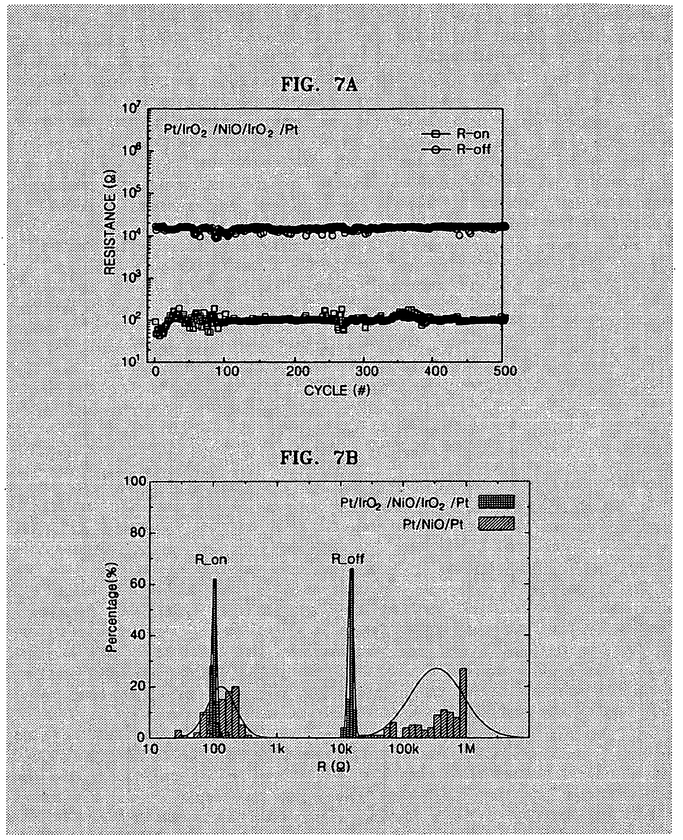

FIG. 6A is a graph illustrating a distribution of set and reset voltage values applied to the storage node illustrated in FIG. 4, and FIG. 6B is a histogram of the set and reset voltage values illustrated in FIG. 6A. FIG. 7A is a graph illustrating a distribution of resistance values of the storage node depending on an on or off state, and FIG. 7B is a histogram of the resistance values of the storage node illustrated in FIG. 7A.

With reference to FIGS. 6A and 6B, a distribution of set and reset voltage values Vset and Vreset with respect to a switching cycle will be closely examined. The storage node 128 according to the present embodiment has the set and reset voltage values Vset and Vreset with decreased standard deviations. Table 1 below exhibits data obtained from measuring set and reset voltage values Vset and Vreset of the conventional M-I-M memory cell structure and the M-B-I-B-M memory cell structure and then comparing average values, standard deviation values, maximum values and minimum values of the measured set voltage values Vset and the reset voltage values Vreset with each other. Herein, the set voltage values Vset and the reset voltage values Vreset are measured in voltages.

**Table 1**

| | Vₛₑₜ Average (Standard Deviation) | Vₛₑₜ Maximum/minimum | Vᵣₑₛₑₜ Average (Standard Deviation) | Vᵣₑₛₑₜ Maximum/minimum |
|---|---|---|---|---|
| Pt/NiO/Pt | 1.78 (0.66) | 4.55/ 1.00 | 0.51 (0.11) | 0.75/0.35 |
| Pt/IrO₂/NiO/IrO₂/Pt (IrO₂: 100 Å) | 1.44 (0.14) | 1.80/ 1.15 | 0.39 (0.02) | 0.40/0.35 |

With reference to FIGS. 7A and 7B, a distribution of resistance values Ron and Roff of the storage node 128 with respect to a switching cycle will be closely examined. The storage node 128 according to the present embodiment has the resistance values Ron and Roff with decreased standard deviations. Table 2 below exhibits data obtained from measuring resistance values Ron and Roff of the conventional M-I-M memory cell structure and the M-B-I-B-M memory cell structure and then comparing average values, standard deviation values, maximum values and minimum values of the measured resistance values Ron and Roff with each other. Herein, the resistance values Ron and Roff are measured in ohms.

**Table 2**

| | Rₒₙ Average (Standard Deviation) | Rₒₙ Maximum/minimum | R_{off} Average (Standard Deviation) | R_{off} Maximum/minimum |
|---|---|---|---|---|
| Pt/NiO/Pt | 151 (66) | 367/28 | 481 k (311 k) | 951 k/ 21 k |
| Pt/IrO₂/NiO/IrO₂/Pt (IrO₂: 100 Å) | 105 (12) | 172/94 | 14.6k (1.3k) | 16.6k/ 10.3k |

Table 3 below exhibits data for a detailed structure of the storage node used in measuring the set and reset voltage values Vset and Vreset and the resistance values Ron and Roff and various sputtering deposition conditions for depositing an IrO₂ contact layer.

**Table 3**

| Sample | Structure | NiO thickness | IrO₂ thickness | Sputter process |
|---|---|---|---|---|
| 1. | Pt/NiO/pt | (500 Å) 50 nm | | Reference sample |
| 2. | Pt/IrO₂/NiO/Pt | (500 Å) 50 nm | (30 Å) 3 nm | 310 °C, 300W, 15 sec. |
| 3. | Pt/lrO₂/NiO/Pt | (500 Å) 50 nm | (100 Å) 10 nm | 310 °C, 300W, 5 sec. |
| 4. | Pt/IrO₂/NiO/IrO₂/Pt | (500 Å) 50 nm | (100 Å) 10 nm | 310 °C, 300W, 15 sec. |
| 6. | Pt/IrO₂/NiO/IrO₂/Pt | (500 Å) 50 nm | (200 Å) 20 nm | 310 °C, 300W, 30 sec. |
| 7. | Pt/IrO₂/NiO/IrO₂/Pt | (500 Å) 50 nm | (500 Å) 50 nm | 310 °C, 300W, 70 sec. |

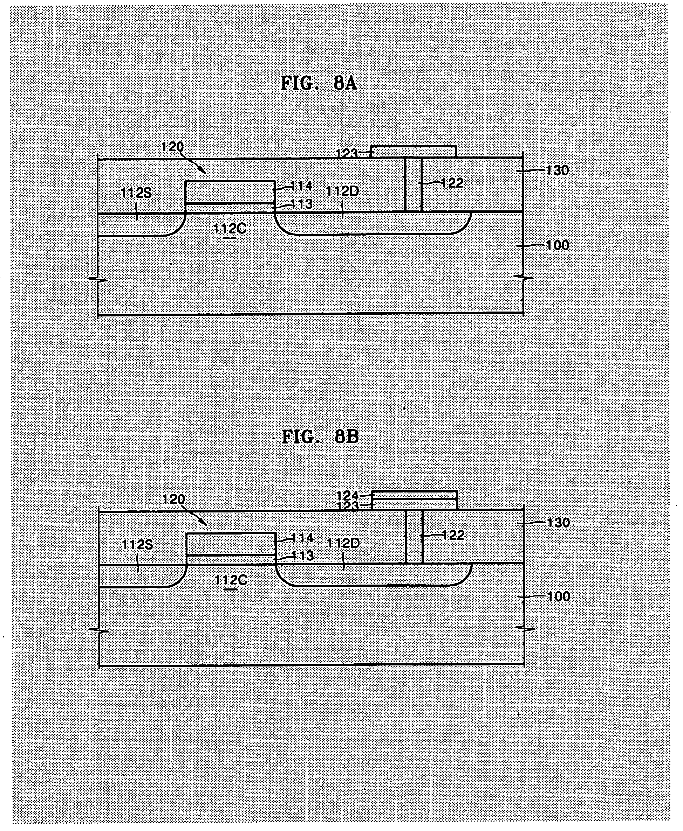

FIGS. 8A through 8E are cross-sectional views illustrating a method of fabricating a non-volatile memory device according to an embodiment of the present invention. Herein, a typical vacuum deposition method such as a chemical vapor deposition (CVD) method or a physical vapor deposition (PVD) method can be used to deposit target layers. The PVD method includes a sputtering method. The non-volatile memory device according to the present embodiment includes a transistor 120, which is a switching device, and a storage node 128 coupled with the transistor 120. Instead of the transistor 120, other switching devices such as diodes can also be used. Since a diode structure and a fabrication method thereof are well known in the art, detailed description thereof will be omitted. Hereinafter, the present embodiment on a fabrication method of such a non-volatile memory device will be described in detail on the basis of the transistor.

Referring to FIG. 8A, the transistor 120, which includes a source 112S, a drain 112D, a channel 112C, and a gate electrode 114, is provided. An insulation layer 130 is formed over the transistor 120. Since a structure of the transistor 120 and a fabrication method thereof are well known in the art, detailed description thereof will be omitted.

A contact hole is formed in the insulation layer 130. The contact hole exposes the source 112S or the drain 112D. A conductive material is then filled into the contact hole to form a contact plug 122. A first electrode 123 is formed over a portion of the insulation layer 130 such that the first electrode 123 contacts the contact plug 122. The first electrode 123 includes one selected from the group consisting of Ir, Pt, Ru, W, TiN, and polysilicon.

Referring to FIG. 8B, a first contact layer 124 is formed over the first electrode 123. The first contact layer 124 includes a conductive metal oxide selected from the group consisting of IrO₂, RuO₂, SrRuO₃, MoO₂, OsO₂, ReO₂, RhO₂, WO₂, and ITO. The first contact layer 124 has a thickness of approximately 1 nm (10 Å) to approximately 50 nm (500 Å).

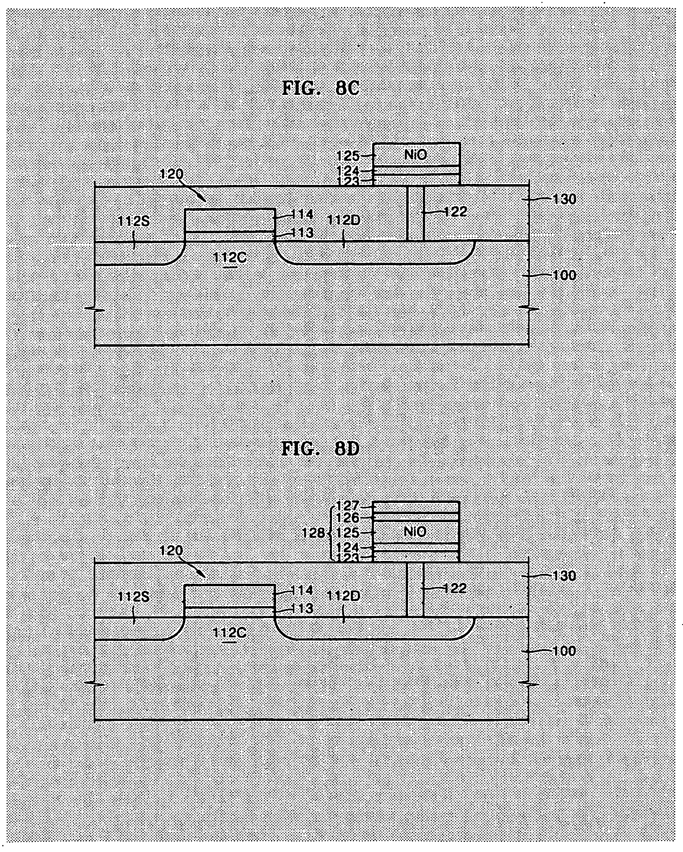

Referring to FIGS. 8C to 8D, a data storage layer 125 is formed over the first contact layer 124. The data storage layer 125 includes a transition metal oxide or aluminum oxide. The transition metal oxide is an oxide of a metal selected from the group consisting of Ni, Nb, Ti, Zr, Hf, Co, Fe, Cu, and Cr. A second contact layer 126 is formed over the data storage layer 125. The second contact layer 126 includes a transition metal oxide selected from the group consisting of IrO₂, RuO₂, SrRuO₃, MoO₂, OsO₂, ReO₂, RhO₂, WO₂, and ITO. The second contact layer 126 has a thickness of approximately 1 nm (10 Å) to approximately 50 nm (500 Å). A second electrode 127 is formed over the second contact layer 126. The second electrode 127 is one selected from the group consisting of Ir, Pt, Ru, W, TiN, and polysilicon.

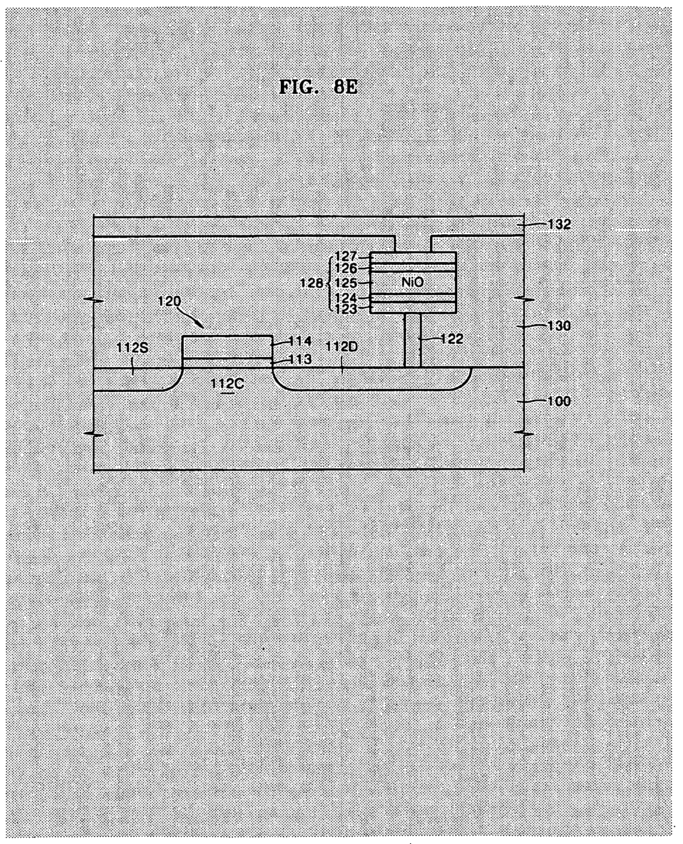

Referring to FIG. 8E, the insulation layer 130 is formed again over the above resultant structure (refer to FIG. 8D) until the insulation layer 130 buries the storage node 128. Another contact hole, which exposes the second electrode 127, is formed in the insulation layer 130, and a plate electrode 132 is formed over the insulation layer 130 and in the other contact hole. Through the above described sequential processes, a non-volatile memory device that has a stable memory switching characteristic in the storage node can be fabricated. Although the storage node 128 according to the present embodiment includes the first contact layer 124 and the second contact layer 126, the storage node 128 in another embodiment of the present invention can include one of the first contact layer 124 and the second contact layer 126.

According to the exemplary embodiments of the present invention, the non-volatile memory device can have a stable memory switching characteristic in the storage node. Using the contact layer formed of a conductive metal oxide such as IrO₂ can improve the interfacial characteristics between the data storage layer and the first electrode and between the data storage layer and the second electrode. As compared with the conventional non-volatile memory device, the improved interfacial characteristics can decrease a deviation of resistance values of the storage node depending on an on or off state, and also a deviation of set and reset voltage values applied to the storage node. Accordingly, a stable memory switching characteristic can be obtained.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A non-volatile memory device, comprising:
a switching device (120); and
a storage node (128) couple with the switching device (120), the storage node including:
a first electrode (123);
a second electrode (127); and
a data storage layer (125) disposed between the first electrode and the second electrode and including a transition metal oxide or aluminum oxide;
**characterized by** at least one contact layer (124,126) disposed beneath and/or above the data storage layer (125) and formed of a conductive metal oxide to improve interfacial characteristics between the data storage layer (125) and the first electrode (123) and/or between the data storage layer (125) and the second electrode (127).

2. The non-volatile memory device of claim 1, wherein the conductive metal oxide is one selected from the group consisting of IrO₂, RuO₂, SrRuO₃, MoO₂, OsO₂, ReO₂, RhO₂, WO₂, and ITO (indium tin oxide).

3. The non-volatile memory device of claim 2, wherein the at least one contact layer (124,126) has a thickness ranging from approximately 1 nm (10 Å) to approximately 50 nm (500 Å).

4. The non-volatile memory device of any preceding claim, wherein the transition metal oxide is an oxide of a metal selected from the group consisting of Ni, Nb, Ti, Zr, Hf, Co, Fe, Cu, and Cr.

5. The non-volatile memory device of any preceding claim, wherein each of the first electrode (123) and the second electrode (127) is formed of a material selected from the group consisting of Ir, Pt, Ru, W, TiN, and polysilicon.

6. The non-volatile memory device of any preceding claim, wherein the switching device comprises a transistor or a diode.

7. A method of fabricating a non-volatile memory device comprising:
preparing a switching device (120);
forming a first electrode (123) coupled with the switching device;
forming a storage node (128) comprising
forming a data storage layer (125) over the first electrode (123) the data storage layer including a transition metal oxide or aluminum oxide; and
forming a second electrode (127) over the data storage layer;
**characterized by** forming a contact layer (124,126) over the first electrode the contact layer (124,126) being disposed beneath and/or above the data storage layer (125) and the contact layer (124) including a conductive metal oxide.

8. The method of claim 7, wherein the conductive metal oxide is one selected from the group consisting of IrO₂, RuO₂, SrRuO₃, MoO₂, OsO₂, ReO₂, Rh02, WO₂, and ITO (indium tin oxide).

9. The method of claim 8, wherein the contact layer (124,126) is formed to a thickness ranging from approximately 1 nm (10 Å) to approximately 50 nm (500 Å).

10. The method of claim 7, 8 or 9 wherein the transition metal oxide is an oxide of a metal selected from the group consisting of Ni, Nb, Ti, Zr, Hf, Co, Fe, Cu, and Cr.

11. The method of claim 7, 8, 9 or 10 wherein each of the first electrode (123) and the second electrode (127) is formed of a material selected from the group consisting of Ir, Pt, Ru, W, TiN, and polysilicon.

12. The method of any of claims 7 to 11, wherein the switching device (120) comprises a transistor or a diode.

13. The method of any of claims 7 to 12 including forming the contact layer as a first contact layer (124) over the first electrode and forming the data storage layer (125) over the first contact layer (124), wherein the second electrode (127) is formed over the data storage layer (125).

14. The method of claim 13, further comprising forming a second contact layer (126) on the data storage layer (125) using a conductive metal oxide between the forming of the data storage layer (125) and the forming of the second electrode (127).

15. The method of claim 14, wherein each of the first contact layer and the second contact layer is formed to a thickness ranging from approximately 1 nm (10 Å) to approximately 50 nm (500 Å).

16. The method of any of claims 7 to 12 including forming the data storage layer over the first electrode and the contact layer as a second contact layer (126) over the data storage layer (125), wherein the second electrode (127)is formed over the contact layer (126).

## Patentansprüche

1. Nichtflüchtige Speicherbauelement, umfassend:
ein Umschaltelement (120) und
einen Speicherknoten (128), der mit dem Umschaltelement (120) gekoppelt ist, wobei der Speicherknoten beinhaltet:
eine erste Elektrode (123),
eine zweite Elektrode (127) und
eine Datenspeicherschicht (125), die zwischen der ersten Elektrode und der zweiten Elektrode angeordnet ist und ein Übergangsmetalloxid oder Aluminiumoxid beinhaltet,
**gekennzeichnet durch** mindestens eine Kontaktschicht (124, 126), die unter und/oder über der Datenspeicherschicht (125) angeordnet ist und aus einem leitfähigen Metalloxid gebildet ist, um die Grenzflächeneigenschaften zwischen der Datenspeicherschicht (125) und der ersten Elektrode (123) und/oder zwischen der Datenspeicherschicht (125) und der zweiten Elektrode (127) zu verbessern.

2. Nichtflüchtiges Speicherbauelement nach Anspruch 1, wobei das leitfähige Metalloxid ausgewählt ist aus der Gruppe bestehend aus IrO₂, RuO₂, SrRuO₃, MoO₂, OsO₂, ReO₂, RhO₂, WO₂ und ITO (Indiumzinnoxid).

3. Nichtflüchtiges Speicherbauelement nach Anspruch 2, wobei die mindestens eine Kontaktschicht (124, 126) eine Dicke im Bereich von ungefähr 1 nm (10 Å) bis ungefähr 50 nm (500 Å) aufweist.

4. Nichtflüchtiges Speicherbauelement nach einem der vorhergehenden Ansprüche, wobei das Übergangsmetalloxid ein Oxid eines Metalls ist, das ausgewählt ist aus der Gruppe bestehend aus Ni, Nb, Ti, Zr, Hf, Co, Fe, Cu und Cr.

5. Nichtflüchtige Speicherbauelement nach einem der vorhergehenden Ansprüche, wobei die erste Elektrode (123) und die zweite Elektrode (127) jeweils aus einem Material gebildet ist, das ausgewählt ist aus der Gruppe bestehend aus Ir, Pt, Ru, W, TiN und Polysilicium.

6. Nichtflüchtiges Speicherbauelement nach einem der vorhergehenden Ansprüche, wobei das Umschaltelement einen Transistor oder eine Diode umfasst.

7. Verfahren zur Herstellung eines nichtflüchtigen Speicherbauelements, umfassend:
Vorbereiten eines Umschaltelements (120),
Ausbilden einer ersten Elektrode (123), die mit dem Umschaltelement gekoppelt ist,
Ausbilden eines Speicherknotens (128), umfassend
Ausbilden einer Datenspeicherschicht (125) über der ersten Elektrode (123), wobei die Datenspeicherschicht ein Übergangsmetalloxid oder Aluminiumoxid beinhaltet, und
Ausbilden einer zweiten Elektrode (127) über der Datenspeicherschicht,
**gekennzeichnet durch** Ausbilden einer Kontaktschicht (124, 126) über der ersten Elektrode, wobei die Kontaktschicht (124, 126) unter und/oder über der Datenspeicherschicht (125) angeordnet wird und die Kontaktschicht (124) ein leitfähiges Metalloxid beinhaltet.

8. Verfahren nach Anspruch 7, wobei das leitfähige Metalloxid ausgewählt wird aus der Gruppe bestehend aus IrO₂, RuO₂, SrRuO₃, MoO₂, OsO₂, ReO₂, RhO₂, WO₂ und ITO (Indiumzinnoxid).

9. Verfahren nach Anspruch 8, wobei die Kontaktschicht (124, 126) so ausgebildet wird, dass sie eine Dicke im Bereich von ungefähr 1 nm (10 Å) bis ungefähr 50 nm (500 Å) aufweist.

10. Verfahren nach Anspruch 7, 8 oder 9, wobei das Übergangsmetalloxid ein Oxid eines Metalls ist, das ausgewählt wird aus der Gruppe bestehend aus Ni, Nb, Ti, Zr, Hf, Co, Fe, Cu und Cr.

11. Verfahren nach Anspruch 7, 8, 9 oder 10, wobei die erste Elektrode (123) und die zweite Elektrode (127) jeweils aus einem Material gebildet wird, das ausgewählt ist aus der Gruppe bestehend aus Ir, Pt, Ru, W, TiN und Polysilicium.

12. Verfahren nach einem der Ansprüche 7 bis 11, wobei das Umschaltelement (120) einen Transistor oder eine Diode umfasst.

13. Verfahren nach einem der Ansprüche 7 bis 12, umfassend Ausbilden der Kontaktschicht als eine erste Kontaktschicht (124) über der ersten Elektrode und Ausbilden der Datenspeicherschicht (125) über der ersten Kontaktschicht (124), wobei die zweite Elektrode (127) über der Datenspeicherschicht (125) ausgebildet wird.

14. Verfahren nach Anspruch 13, weiter umfassend Ausbilden einer zweiten Kontaktschicht (126) auf der Datenspeicherschicht (125) unter Verwendung eines leitfähigen Metalloxids zwischen dem Ausbilden der Datenspeicherschicht (125) und dem Ausbilden der zweiten Elektrode (127).

15. Verfahren nach Anspruch 14, wobei die erste Kontaktschicht und die zweite Kontaktschicht jeweils so ausgebildet werden, dass sie eine Dicke im Bereich von ungefähr 1 nm (10 Å) bis ungefähr 50 nm (500 Å) aufweisen.

16. Verfahren nach einem der Ansprüche 7 bis 12, umfassend Ausbilden der Datenspeicherschicht über der ersten Elektrode und der Kontaktschicht als eine zweite Kontaktschicht (126) über der Datenspeicherschicht (125), wobei die zweite Elektrode (127) über der Kontaktschicht (126) ausgebildet wird.

## Revendications

1. Dispositif de mémoire non volatile, comprenant :
un dispositif de commutation (120) ; et
un noeud de stockage (128) couplé au dispositif de commutation (120), le noeud de stockage comportant :
une première électrode (123) ;
une seconde électrode (127) ; et
une couche de stockage de données (125) agencée entre la première électrode et la seconde électrode et comportant un oxyde métallique de transition ou un oxyde d'aluminium ;
**caractérisée en ce qu'**il compote au moins une couche de contact (124, 126) agencée au-dessous et/ou au-dessus de la couche de stockage de données (125) et formée d'un oxyde métallique conducteur pour améliorer les caractéristiques d'interfaçage entre la couche de stockage de données (125) et la première électrode (123) et/ou entre la couche de stockage de données (125) et la seconde électrode (127).

2. Dispositif de mémoire non volatile selon la revendication 1, dans lequel l'oxyde métallique conducteur est sélectionné dans le groupe comportant : IrO₂, RuO₂, SrRuO₃, MoO₂, OsO₂, ReO₂, RhO₂, WO₂, et ITO (oxyde d'indium-étain).

3. Dispositif de mémoire non volatile selon la revendication 2, dans lequel ladite au moins une couche de contact (124, 126) présente une épaisseur allant d'environ 1 nm (10 Å) à environ 50 nm (500 Å).

4. Dispositif de mémoire non volatile selon l'une quelconque des revendications précédentes, dans lequel l'oxyde métallique de transition est un oxyde d'un métal sélectionné dans le groupe comportant : Ni, Nb, Ti, Zr, Hf, Co, Fe, Cu et Cr.

5. Dispositif de mémoire non volatile selon l'une quelconque des revendications précédentes, dans lequel chaque électrode, parmi la première électrode (123) et la seconde électrode (127), est formée d'un matériau choisi dans le groupe comportant : Ir, Pt, Ru, W, TiN et poly-silicium.

6. Dispositif de mémoire non volatile selon l'une quelconque des revendications précédentes, dans lequel le dispositif de commutation comprend un transistor ou une diode.

7. Procédé de fabrication d'un dispositif de mémoire non volatile, comprenant les étapes ci-dessous consistant à :
préparer d'un dispositif de commutation (120) ;
former une première électrode (123) couplée au dispositif de commutation ;
former un noeud de stockage (128), comportant les étapes ci-dessous consistant à :
former une couche de stockage de données (125) sur la première électrode (123), la couche de stockage de données comportant un oxyde métallique de transition ou un oxyde d'aluminium ; et
former une seconde électrode (127) sur la couche de stockage de données ;
**caractérisé par** l'étape consistant à former une couche de contact (124, 126) sur la première électrode, la couche de contact (124, 126) étant agencée au-dessous et/ou au-dessus de la couche de stockage de données (125), et la couche de contact (124) comportant un oxyde métallique conducteur.

8. Procédé selon la revendication 7, dans lequel l'oxyde métallique conducteur est l'un sélectionné dans le groupe comportant : IrO₂, RuO₂, SrRuO₃, MoO₂, OsO₂, ReO₂, RhO₂, WO₂, et ITO (oxyde d'indium-étain).

9. Procédé selon la revendication 8, dans lequel la couche de contact (124, 126) est formée avec une épaisseur allant d'environ 1 nm (10 Å) à environ 50 nm (500 Å).

10. Procédé selon la revendication 7, 8 ou 9, dans lequel l'oxyde métallique de transition est un oxyde d'un métal sélectionné dans le groupe comportant : Ni, Nb, Ti, Zr, Hf, Co, Fe, Cu et Cr.

11. Procédé selon la revendication 7, 8, 9 ou 10, dans lequel chaque électrode, parmi la première électrode (123) et la seconde électrode (127), est formée d'un matériau choisi dans le groupe comportant : Ir, Pt, Ru, W, TiN et poly-silicium.

12. Procédé selon l'une quelconque des revendications 7 à 11, dans lequel le dispositif de commutation (120) comprend un transistor ou une diode.

13. Procédé selon l'une quelconque des revendications 7 à 12, comportant les étapes consistant à former la couche de contact en qualité de première couche de contact (124) sur la première électrode, et former la couche de stockage de données (125) sur la première couche de contact (124), dans lequel la seconde électrode (127) est formée sur la couche de stockage de données (125).

14. Procédé selon la revendication 13, comprenant en outre l'étape consistant à former une seconde couche de contact (126) sur la couche de stockage de données (125) en utilisant un oxyde métallique conducteur entre la formation de la couche de stockage de données (125) et la formation de la seconde électrode (127).

15. Procédé selon la revendication 14, dans lequel chaque couche, parmi la première couche de contact et la seconde couche de contact, est formée avec une épaisseur allant d'environ 1 nm (10 Å) à environ 50 nm (500 Å).

16. Procédé selon l'une quelconque des revendications 7 à 12, comportant l'étape consistant à former la couche de stockage de données sur la première électrode et la couche de contact, en qualité de seconde couche de contact (126), sur la couche de stockage de données (125), dans lequel la seconde électrode (127) est formée sur la couche de contact (126).
